# EUROPEAN PATENT SPECIFICATION

(11) **EP 0 670 601 B1**
(45) Date of publication and mention of the grant of the patent: **02.05.2002**
(21) Application number: 95301349.7
(22) Date of filing: 02.03.1995
(51) Int. Cl.: H01L 27/02

(54) **Insulated gate-type bipolar transistor**
Bipolartransistor mit isoliertem Gate
Transistor bipolaire à grille isolée

(30) Priority: 04.03.1994 JP 3398594
(43) Date of publication of application: 06.09.1995
(73) Proprietor: FUJI ELECTRIC CO. LTD., Kawasaki 210 (JP)
(72) Inventor: Yamazaki, Tomoyuki, Kawasaki-ku, Kawasaki 210 (JP); Obinata, Shigeyuki, Kawasaki-ku, Kawasaki 210 (JP)
(74) Representative: Bridge-Butler, Alan James

(56) References cited:
- EP-A- 0 109 070
- EP-A- 0 314 465
- DE-A- 4 209 148
- PATENT ABSTRACTS OF JAPAN vol. 018 no. 035 (E-1494) ,19 January 1994 & JP-A-05 267675 (FUJI ELECTRIC CO LTD) 15 October 1993,

## Description

The present invention relates to semiconductors, and is particularly concerned with an insulated gate bipolar transistor (IGBT) chip which can act as a power-switching device and is applicable to inverters and other similar devices.

An insulated gate bipolar transistor (hereinafter referred to as IGBT) is a voltage-driven semiconductor switching device capable of a high-speed turning-off operation with relatively low voltage application, which is used widely in the field of power electronics, for example, in inverters and other similar devices.

An IGBT output inverter device may have an overcurrent flow into the IGBT if there is an inrush current when a motor is actuated, or a failure such as a load short circuit or an arm short circuit occurs. Hence, superior electrical characteristics are required for the IGBT against a high voltage and large current, and among the electrical characteristics especially required is a breakdown withstand capability known as a short-circuit withstand capability.

Conventionally, an inverter device incorporates a protection circuit to detect short-circuit failures when they occur, and turn the power supply off. Such a protection circuit generally requires from 10 to 20µsec to detect the overcurrent and engage its protective function, and it is imperative that the IGBT must not break down during this interval.

Therefore, many recent high-performance IGBT modules adopt an overcurrent protection system which is disposed independently of the protection circuit in the inverter device and which can quickly detect an overcurrent flowing into the IGBT when a short-circuit failure occurs, and which can limit the current in the IGBT and suppress it to within the short-circuit withstand capability of the semiconductor elements. This is achieved by means of a gate control based on this overcurrent detection signal, which operates before the power supply is turned off by the protection circuit.

DE-A-42 09 148 describes an IGBT having an overload detector of the same construction as the IGBT, a current detector and a field effect transistor for lowering the voltage applied to a common insulated gate.

EP-A-0 314 456 describes a vertical MOSFET and a peripheral circuit element integrated on the same chip, for example for limiting current.

Patent Abstracts of Japan, vol 18, no. 35 (E-1494) and JP-A-5267675 describes an IGBT with a current limiting device formed on a common metal substrate.

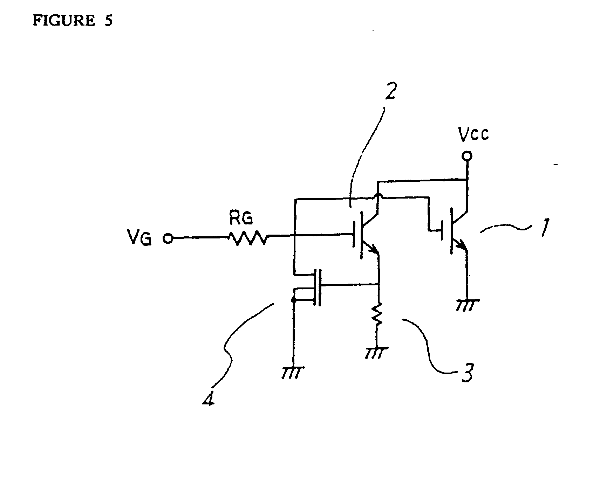

Figure 5 shows an IGBT overcurrent protection circuit incorporating the protection system described above. In the figure, a main element (IGBT) 1 has a current-detection sub-element 2 (a different IGBT from the main element 1) connected in parallel to the main element 1. A current-detection resistance 3 is connected in series to the sub-element 2, and a switching element (MOSFET) 4 is connected to the gate-driving circuits for the main element 1 and the sub-element 2 to perform on-off operation according to the voltage generated between the ends of the current-detection resistance 3.

Given such a configuration, when an overcurrent due to a load short-circuit failure or the like flows into the main element 1 and the sub-element 2, the voltage generated between the ends of the current-detection resistance 3 exceeds the threshold voltage of the switching element 4 and the switching element 4 turns on. This reduces the gate voltage of both the main element 1 and the current-detection sub-element 2, and the main current flowing in the IGBT main element is thus limited. In this case, the main current flowing in the IGBT main element to be protected can be suppressed to within the short-circuit withstand capability of the IGBT element by selecting appropriate values for the resistance of the current-detection resistance 3 and the threshold voltage of the switching element 4.

In the meantime, when an overcurrent protection circuit that includes the IGBT sub-element 2 for current detection is constructed as an external, independent circuit to protect the IGBT main element 1 as described above, it is technically difficult to maintain the operational characteristics of the main element 1 proportional to those of the sub-element 2. In other words, since the short-circuit phenomena in an inverter include various different modes such as an arm short circuit, series short circuit, output short circuit and earth fault, and it is anticipated that the collector-to-emitter voltage V_{CE} applied to the IGBT element to be protected will vary according to the short circuit mode, the current ratio between the main element 1 and the sub-element 2 may vary, and if the collector-to-emitter voltage V_{CE} varies as described above, the value to which the main current is limited may also vary, making a stable overcurrent protection operation difficult.

To solve the above problem, a configuration has already been proposed in European Patent Application 94307477.3, corresponding to the published European Patent Application EP-A2-649176, this being an Art 54(3) document, not relevant to inventive step, wherein some of the cells formed integrally on a semiconductor substrate are used as sensing cells to detect the current in the IGBT main element, and the emitter electrodes of the sensing cells are laid out separately from the emitter electrodes of the main cells formed on the same substrate and connected to a current-detection resistance in an overcurrent protection circuit.

In the construction that incorporates the main cells (IGBT) and the sensing cells to detect the current (IGBT) on the same semiconductor substrate as described above, the gate electric potential of the sensing cell may change with a voltage drop at the current-detection resistance of the overcurrent protection circuit which is connected to the sensing cells, depending on the positioning of the sensing cells and the IGBT output characteristics. The change in electrical potential generates a difference in the current density between the main cells and the sensing cells, causing the current ratio to vary. Experimental results have shown that the change in electrical potential also causes the value of the limited current to change if the collector-to-emitter voltage V_{CE} changes. In particular the value of the limited current increases in a low voltage region in which the collector-to-emitter voltage V_{CE} is low.

Moreover, if the voltage dependence of the value of the limited current increases, difficulties may arise in the overcurrent protection operations if the IGBT forms part of an inverter device. Hence, it is necessary to suppress the voltage dependence of the value of the limited current, keeping the dependance as low as possible.

The present invention is intended to solve the above problems, and thereby provides an insulated gate bipolar transistor chip with an overcurrent-limiting function that is capable of keeping the ratio of the main current to the detection current constant even in different operating environments, while at the same time suppressing the voltage dependence of the value of the limited current when a load short circuit occurs to ensure reliable overcurrent protection.

In the construction that incorporates the main cells (IGBT) and the sensing cells for current detection (IGBT) on the same semiconductor substrate as described above, it was found by performing various experiments and considerations that the disadvantages which are explained below occur due to its characteristics. That is, depending on the position of the sensing cells to be assembled on the semiconductor substrate, mutual interference between carriers may occur in the boundary region of the main cell and sensing cell, which causes the ratio of the main current flowing in the main cells to the current flowing in the sensing cells to change. Furthermore, in IGBT elements, a difference in current density due to gate potential difference is generated between the sensing cell whose emitter potential has risen due to the current-detection resistance in the overcurrent protection circuit, and the main cell whose emitter at an earth potential. As a result, the values to which the main current is limited due to overcurrent protection vary as the collector-to-emitter voltage V_{CE} changes, and therefore, the value of the limited current tends to increase in a low voltage region where the collector-to-emitter voltage V_{CE} is low.

Moreover, if the voltage dependence of the value of the limited current increases, difficulties may occur in overcurrent protection operations if the IGBT is applied in an inverter device. Hence it is necessary to suppress the voltage dependence of the value of the limited current, keeping it as low as possible.

The present invention is intended to solve the above problems, and thereby provides an insulated gate-type bipolar transistor with an overcurrent-limiting function that is capable of maintaining the ratio of the main current to the detection current constant even in different operating environments, while suppressing the voltage dependence of the value of the limited current when a load short circuit occurs by incorporating with an overcurrent protection circuit to ensure reliable overcurrent protection.

According to the present invention there is provided an insulated gate bipolar transistor chip connected to an overcurrent protection circuit and comprising:
a plurality of insulated gate bipolar transistors connected to an overcurrent protection circuit which are formed integrally on a surface of a semiconducting substrate and each have (a) a p base region formed as an island on said surface, (b) an n emitter formed as an island on a surface of the p base region, (c) a gate electrode, and (d) an emitter electrode; and
at least a sensing cell for current detection having a p base region formed as an island in part of the semiconductor substrate, an n emitter region formed as an island on a surface of the p base region, a gate electrode and an emitter electrode, the emitter electrode of the sensing cell being separated from the emitter electrodes of the transistors and connected to said protection circuit, wherein the distance between the p base region of the sensing cell and the p base region of the adjoining transistor(s) is greater than 100µm.

In addition, the following morphologies are taken as specific means to separate the sensing cell from the transistor:
(1) In an arrangement according to item (1) above, P-wells for drawing out hole current connected to emitter electrodes of the transistors are formed in a region along the circumference of the sensing cell.
(2) A separation region is formed between the sensing cell and the adjoining transistor.

In the above configuration, the current flowing into the IGBT is detected by the current-detection resistance in the overcurrent protection circuit connected to the emitter electrodes via the sensing cells for current detection formed on the same substrate as for the transistors, and if an overcurrent due to a load short circuit, etc. flows, the main current is limited by the protection circuit operation to within the short-circuit withstand capability of the IGBT to protect cells from breaking down. While this overcurrent protection operation is of the same system as the conventional system, the current interference between the transistors and sensing cells is suppressed, the current ratio between the transistors and sensing cells is maintained constant, and the voltage dependence of the value of the limited current due to the change in current ratio is suppressed, by laying out the sensing cells on the semiconductor substrate so that they are separated from the transistors by spacing the sensing cells from the transistors at such a distance as not to be affected by the current, or by disposing a separation region (for example trench separation, dielectric separation, etc) between the sensing cells and transistors.

In addition, the carrier interference in the boundary region between the transistors and sensing cells may be avoided by forming P-wells to draw out the hole current that are connected to the emitter electrodes of the transistors in a region along the circumference of the sensing cells.

Embodiments of the present invention will now be explained in detail with reference to the accompanying drawings, in which;
Figure 1(a) is a plan view of a chip, to illustrate the configuration of the insulated gate bipolar transistor chip according to one embodiment of the present invention;
Figure 1(b) is a cross-sectional view of an IGBT formed in a chip as seen in Figure 1(a);
Figure 2 is an expanded view of a sensing cell in the chip illustrated in Figure 1;
Figure 3 is a voltage and current waveform chart observed in a load short-circuit test performed by connecting a protection circuit to the IGBT chip in Figure 1;
Figure 4 is a characteristics graph illustrating the relationship between the power supply voltage and the value of the limited current by comparing an embodiment of the present invention with the prior art; and
Figure 5 is a diagram of an overcurrent protection circuit in an IGBT.

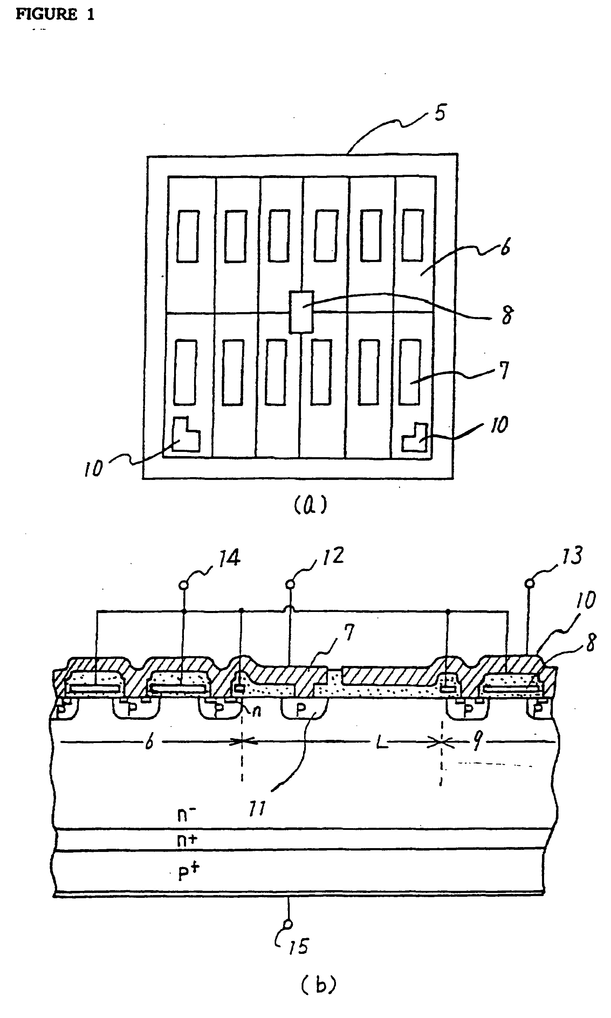

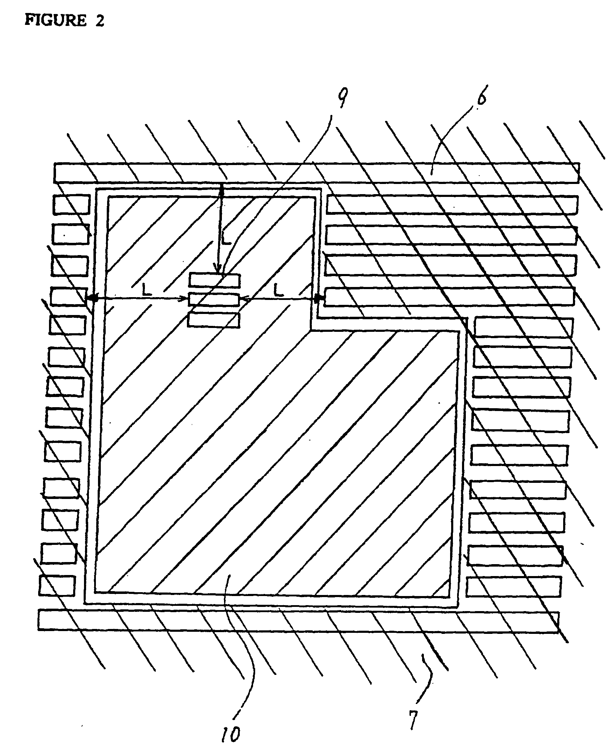

Referring now to the drawings, Figures 1(a) and 1(b) are a plan view of an IGBT chip and a cross-sectional view of a cell construction, respectively, and Figure 2 is an expanded view of the sensing cells in Figure 1. A semiconductor substrate 5 has a large number of n-channel type IGBTs as the main cells 6 which are laid out in stripes parallel to each other, and the main emitter electrodes 7 and the gate electrodes 8 are formed for the IGBTs of the main cells 6. In addition, the same IGBTs as the main cells 6 are incorporated as the sensing cells 9 on part of the semiconductor substrate 5, and the sensing cells 9 have emitter electrodes 10 for current detection which are formed separately and independently from the emitter electrodes 7 of the main cells 6. Furthermore, P-wells 11 which draw out the hole current are formed in a region along the circumference of the sensing cells 9 so as to surround the sensing cells 9. The P-wells 11 are connected to the emitter electrodes 7 of the main cells 6.

In this construction, the sensing cells 9 are laid out on the semiconductor substrate 5 so as to ensure that a distance L of at least 100µm exists between the sensing cells 9 and the main cells 6 adjacent to the sensing cells, considering the diffusion length of the electrons injected from the emitter side. For example, the distance L may advantageously be about 200µm where the semiconductor substrate 5 has a resistivity of 80Ωcm, an n- drift layer thickness of 80µm, and uses a power supply voltage of 400V.

In Figure 1(b), a main emitter terminal 12, a current detection emitter terminal 13, a gate terminal 14, and a collector terminal 15 are shown, with the overcurrent protection circuit for the main cells constructed by connecting the current detection emitter terminal 13 to the current detection resistance 3 shown in Figure 5. The current-detection resistance 3 in the overcurrent detection circuit and the switching sub-elements 2 may be constructed as an external circuit separated from the IGBTs, or may be formed around the gate electrode on the semiconductor substrate 5.

While the overcurrent protection operation of the IGBT according to the above construction is nearly the same as that which occurs in the circuit illustrated in Figure 5, the carrier interference is almost completely eliminated in the boundary region between the main cells and sensing cells by setting the distance L between the main cells 6 and sensing cells 9 at 100µm or more to separate them, and further by forming P-wells 11 for drawing out the hole current alongside the main cells 6 so that the P-wells 11 surround the area of the sensing cells 9. This construction allows the current ratio between the main current and the detected current to be maintained constant, and the value of the limited current of the main current to be restricted to nearly a constant value within the short-circuit withstand capability, when overcurrent limitation is performed at a load short circuit, without being affected by the change in the collector-to-emitter voltage.

In addition, means to electrically separate the sensing cells 9 from the main cells 6 include forming a separation region such as by means of trench separation or dielectric separation between the sensing cells 9 and the main cells 6, in addition to setting the distance L by considering the electron diffusion length between both cells as shown in the illustrated embodiment. In this case, it is possible to lay out the sensing cells 9 in proximity to the main cells 6.

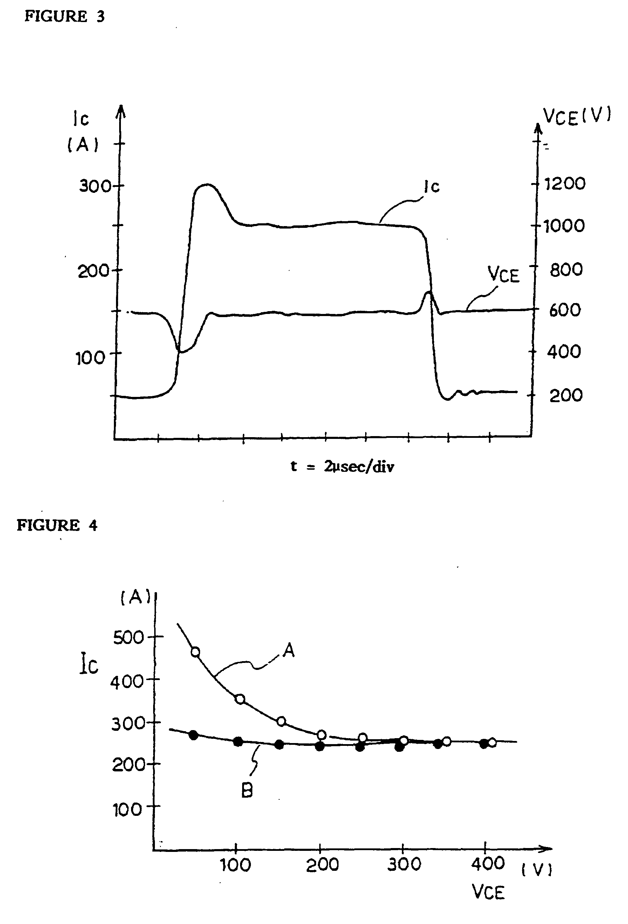

Next, Figure 3 shows waveforms of the main current Ic and the voltage V_{CE} observed in a short-circuit test using the overcurrent protection circuit connected to the IGBT with the above configuration (with a withstand voltage of 600V, and a rated current of 100A) and using a power supply voltage of 400V. As can be seen from this waveform graph, the main current in the IGBT is reduced in a period of a few microseconds so that the value of the limited current relative to the rated current of 100A is within the short-circuit withstand capability of 250A.

Figure 4 is a graph that illustrates the characteristics of the value to which the main current is limited in an overcurrent event when the power supply voltage applied across the collector and the emitter changes, in order to compare the embodiment with a conventional system wherein the distance between the sensing cells and main cells is as close as 20µm or less. The tested IGBT shown in this graph is an element with a large gain, wherein the prior art using this type of element shows a trend in which the value of the limited current increases in a low voltage region as shown by line "A", while in the present invention the value of the limited current remains the same from a high voltage region to low voltage region as shown by line "B". This shows that the voltage dependence of the value of the limited current is greatly improved. This effect further stabilises overcurrent protection when the IGBT is used in an inverter device regardless of which of the short-circuit modes occurs.

As described above, forming the sensing cells for current detection on a part of a semiconductor substrate with a large number of main cells that are formed integrally, and laying out the sensing cells so as to be electrically separated from the main cells, the present invention allows an overcurrent flowing in the IGBT to be detected via the sensing cells with high accuracy, while the current ratio of the main cells to the sensing cells is maintained constant, and thereby allows the power supply voltage dependence of value of the limited current to be suppressed to a low value, thus achieving stable overcurrent protection.

## Claims

1. An insulated gate bipolar transistor chip connected to an overcurrent protection circuit and comprising:
a plurality of insulated gate bipolar transistors (6) which are formed integrally on a surface of a semiconductor substrate(s) and each have (a) a p base region (P) formed as an island on said surface, (b) an n emitter (n) formed as an island on a surface of the p base region (P), (c) a gate electrode (8), and (d) an emitter electrode (7); and
at least a sensing cell (9) for current detection having a p base region (P) formed as an island in part of the semiconductor substrate (5), an n emitter region formed as an island on a surface of the p base region, a gate electrode (8) and an emitter electrode (10), the emitter electrode of the sensing cell (9) being separated from the emitter electrodes (7) of the transistors (6) and connected to said protection circuit,
**characterised in that** the distance between the p base region of the sensing cell (9) and the p base region of the adjoining transistors (6) is greater than 100µm.

2. An insulated gate bipolar transistor chip as claimed in claim 1, **characterised in that** P-wells (11) for hole-current extraction detection which are connected to the emitter electrodes (7) of the said transistors (6) are formed in a region along the circumference of the p base region of the sensing cell (9).

3. An insulated gate bipolar transistor chip as claimed in claim 1 or 2, **characterised in that** a separation region is formed between the sensing cell (9) and the adjoining said transistors (6).

## Patentansprüche

1. Bipolartransistorchip mit isoliertem Gate, verbunden mit einer Überstromschutzschaltung und umfassend:
eine Mehrzahl von Bipolartransistoren mit isoliertem Gate (6), welche auf der Oberftäche eines Halbleitersubstrats (5) integrlert angeordnet sind und welche jeweils (a) eine p-Basiszone (P), die als Insel auf der Oberfläche angeordnet ist, (b) einen n-Emitter (n), der als Insel auf einer Oberfläche der p-Basiszone (P) angeordnet ist, (c) eine Gate-Elektrode(8) und (d) eine Emitter-Elektrode (7) aufweisen; und
wenigstens eine Abtastzelle (9) zur Stromdetektion mit einer p-Basiszone (P), die als teilweise Insel des Halbleitersubstrats (5) angeordnet ist, einer n-Emitter-Zone, die als Insel auf einer Oberfläche der p-Basiszone angeordnet ist, einer Gate-Elektrode (8) und einer Emitter-Elektrode (10), wobei: die Emitter-Elektrode der Abtastzelle (9) von den Emitter-Elektroden (7) der Transistoren (6) getrennt ist und mit der Schutzschaltung verbunden ist,
**dadurch gekennzeichnet, daß** der Abstand zwischen der p-Basiszone der Abtastzelle (9) und der p-Basiszone der angrenzenden Transistoren (6) größer als 100 µm ist.

2. Bipolartransistorchip mit isoliertem Gate nach Anspruch 1, **dadurch gekennzeichnet, daß** P-Senken(11) zur Löcherstromextraktionsdetektion, welche mit den Emitter-Elektroden (7) der Transistoren (6) verbunden sind, in einer Zone entlang der Peripherie der p-Basiszone der Abtastzelle (9) angeordnet sind.

3. Bipolartransistorchip mit isoliertem Gate nach Anspruch 1 oder 2, **dadurch gekennzeichnet, daß** eine Trennungszone zwischen der Abtastzelle (9) und den angrenzenden Transistoren (6) eine Trennungszone angeordnet ist.

## Revendications

1. Puce à transistors bipolaires à grille isolée, reliée à un circuit de protection contre les surintensités et comprenant :
une pluralité de transistors bipolaires (6) à grille isolée qui sont formés d'un seul tenant sur une surface d'un substrat semi-conducteur (5) et ont chacun (a) une région de base p (P) sous la forme d'un îlot sur ladite surface, (b) un émetteur n (n) sous la forme d'un îlot sur une surface de la région de base p (P), (c) une électrode de grille (8), et (d) une électrode d'émetteur (7) ; et
au moins une cellule de détection (9) de courant ayant une région de base p (P) sous la forme d'un îlot dans une partie du substrat semi-conducteur(5), une région d'émetteur n sous la forme d'un îlot sur une surface de la région de base p, une électrode de grille (8) et une électrode d'émetteur (10), l'électrode d'émetteur de la cellule de détection (9) étant séparée des électrodes d'émetteur (7) des transistors (6) et connectée audit circuit de protection,
**caractérisée en ce que** la distance entre la région de base p de la cellule de détection (9) et la région de base p des transistors adjacents (6) est supérieure à 100 µm.

2. Puce à transistors bipolaires à grille isolée selon la revendication 1, **caractérisée en ce que** des puits-P (11) pour la détection de l'extraction de courant de trous, qui sont connectés aux électrodes d'émetteur (7) desdits transistors (6), sont formés dans une région située sur le pourtour de la région de base p de la cellule de détection (9).

3. Puce à transistors bipolaires à grille isolée selon la revendication 1 ou 2, **caractérisée en ce qu'**une région de séparation est formée entre la cellule de détection (9) et lesdits transistors adjacents (6).
